# EUROPEAN PATENT APPLICATION

(11) **EP 4 671 661 A1**
(43) Date of publication of application: **31.12.2025**
(21) Application number: 24760137.0
(22) Date of filing: 07.02.2024
(51) Int. Cl.: F28D 15/04, F28D 15/02, H01L 23/427, H05K 7/20

(54) **HEAT PIPE, ELECTRONIC DEVICE, INSTRUMENT, AND METHOD FOR MANUFACTURING HEAT PIPE**

(30) Priority: 21.02.2023 JP 2023025494
(71) Applicant: Sony Interactive Entertainment Inc., Tokyo 108-0075 (JP)
(72) Inventor: SASAKI, Chiyoshi, Tokyo 108-0075 (JP); TSUCHIDA, Shinya, Tokyo 108-0075 (JP); TANIMOTO, Naoki, Tokyo 108-0075 (JP)
(74) Representative: Fish & Richardson P.C.
(86) International application number: PCT/JP2024/004171
(87) International publication number: WO 2024/176835

(57) **Abstract**

Heat circulation is performed efficiently regardless of a usage posture of a heat pipe (20). The heat pipe (20) is a heat pipe that includes a tubular body (21) in which a working fluid is to be sealed and a sintered body layer (22) formed by sintering metal powder on an inner wall surface (21a) of the tubular body (21). The heat pipe (20) includes an evaporation section (201) in which the working fluid evaporates, a condensation section (202) in which the working fluid condenses, and an intermediate section (203) positioned between the evaporation section (201) and the condensation section (202). At least the intermediate section (203) includes, in a cross section taken along a direction intersecting with an extension direction of the heat pipe (20), a first thick portion having a first thickness (t1) and a second thick portion having a second thickness (t2), the second thickness (t2) being larger than the first thickness (t1). The first thick portion and the second thick portion of the intermediate section (203) face each other at least in part through a center of the tubular body (21). The second thick portion includes a combination of the tubular body (21) and the sintered body layer (22).

## Description

### [Technical Field]

The present disclosure relates to a heat pipe, an electronic device, an instrument, and a method for manufacturing the heat pipe.

### [Background Art]

As disclosed in PTL 1, cooling fans, heat sinks, heat pipes, and the like configured to cool heat-generating components on circuit boards are disposed within electronic devices such as game consoles, personal computers, and server computers. Further, as disclosed in PTL 2, a wick including sintered metal powder is provided on an inner wall of a heat pipe. A working fluid sealed in the heat pipe circulates by using capillary action of the wick.

### [Citation List]

### [Patent Literature]

[PTL 1]
   PCT Patent Publication No. WO2021/193879
[PTL 2]
   Japanese Patent Laid-open No. 2002-318085

### [Summary]

### [Technical Problem]

Here, since the working fluid sealed in the heat pipe is affected by gravity, circulation efficiency of the working fluid varies depending on a usage posture of the electronic device, in some cases. Therefore, there is a demand for a heat pipe capable of maintaining heat circulation efficiency regardless of the usage posture.

It is an object of the present disclosure to provide a heat pipe capable of efficiently performing heat circulation regardless of the usage posture, an electronic device, an instrument, and a method for manufacturing the heat pipe.

### [Solution to Problem]

A heat pipe proposed in the present disclosure is a heat pipe that includes a tubular body in which a working fluid is to be sealed and a sintered body layer formed by sintering metal powder on an inner wall surface of the tubular body, the heat pipe including an evaporation section in which the working fluid evaporates, a condensation section in which the working fluid condenses, and an intermediate section positioned between the evaporation section and the condensation section. At least the intermediate section includes, in a cross section taken along a direction intersecting with an extension direction of the heat pipe, a first thick portion having a first thickness and a second thick portion having a second thickness, the second thickness being larger than the first thickness. The first thick portion and the second thick portion of the intermediate section face each other at least in part through a center of the tubular body in the cross section. The second thick portion includes a combination of the tubular body and the sintered body layer.

An electronic device proposed in the present disclosure is an electronic device having a housing for accommodating a heat-generating component, a heat-dissipating component, and a heat pipe that includes a tubular body in which a working fluid is to be sealed and a sintered body layer formed by sintering metal powder on an inner wall surface of the tubular body. The heat pipe includes an evaporation section in which the working fluid evaporates due to heat from the heat-generating component, a condensation section in which the working fluid condenses due to a heat dissipation effect of the heat-dissipating component, and an intermediate section positioned between the evaporation section and the condensation section. At least the intermediate section includes, in a cross section taken along a direction intersecting with an extension direction of the heat pipe, a first thick portion having a first thickness and a second thick portion having a second thickness, the second thickness being larger than the first thickness. The first thick portion and the second thick portion of the intermediate section face each other at least in part through a center of the tubular body in the cross section. The second thick portion includes a combination of the tubular body and the sintered body layer.

An instrument proposed in the present disclosure is an instrument to be used for forming a sintered body layer in a heat pipe that includes a tubular body in which a working fluid is to be sealed and the sintered body layer formed by sintering metal powder on an inner wall surface of the tubular body, the instrument including a first extension part extending in an extension direction of the tubular body and a second extension part extending in the extension direction of the tubular body from an end portion of the first extension part. A length from a center of the second extension part to an outer wall surface thereof in a cross section taken along a direction intersecting with an extension direction of the second extension part is smaller than a length from a center of the first extension part to an outer wall surface thereof in a cross section taken along a direction intersecting with an extension direction of the first extension part. The first extension part includes a portion having a small length from the center to the outer wall surface of the first extension part in the cross section taken along the direction intersecting with the extension direction of the first extension part.

A method for manufacturing a heat pipe proposed in the present disclosure is a method for manufacturing a heat pipe that includes a tubular body in which a working fluid is to be sealed and a sintered body layer formed by sintering metal powder on an inner wall surface of the tubular body, the method including the steps of inserting an instrument extending in an extension direction of the tubular body into the tubular body, filling a gap between the inner wall surface of the tubular body and an outer wall surface of the instrument with metal powder, and forming the sintered body layer in the gap by sintering the metal powder. The gap includes a first filling region and a second filling region. The second filling region has a larger width in a thickness direction of the tubular body than the first filling region. The first filling region includes a region part of which has a large width in the thickness direction of the tubular body.

### [Brief Description of Drawings]

[FIG. 1A]

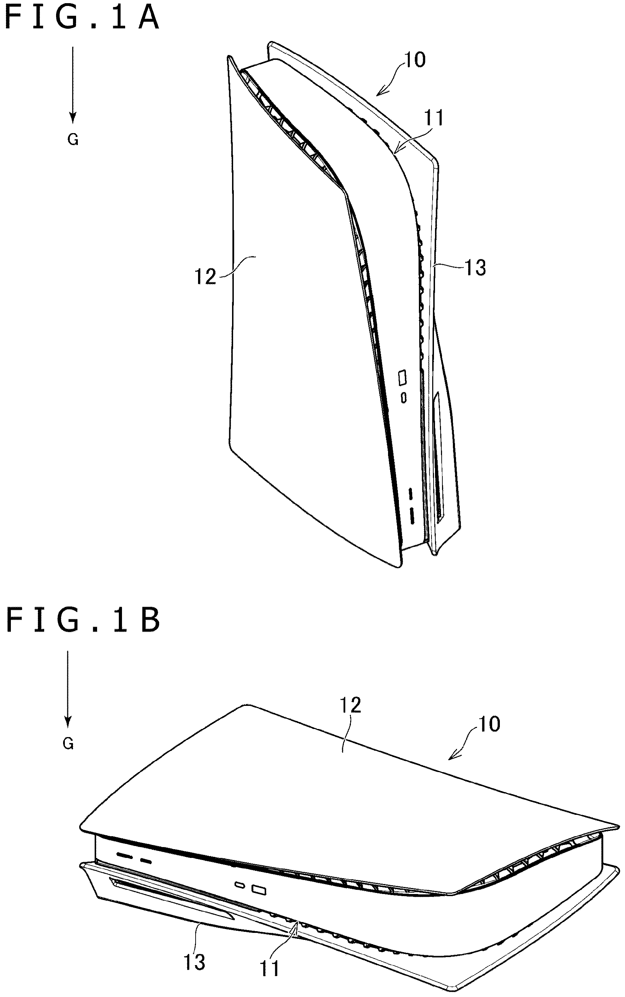

   FIG. 1A is a perspective view illustrating an example of an electronic device in a vertical posture.
[FIG. 1B]
   FIG. 1B is a perspective view illustrating an example of the electronic device in a horizontal posture.
[FIG. 2]

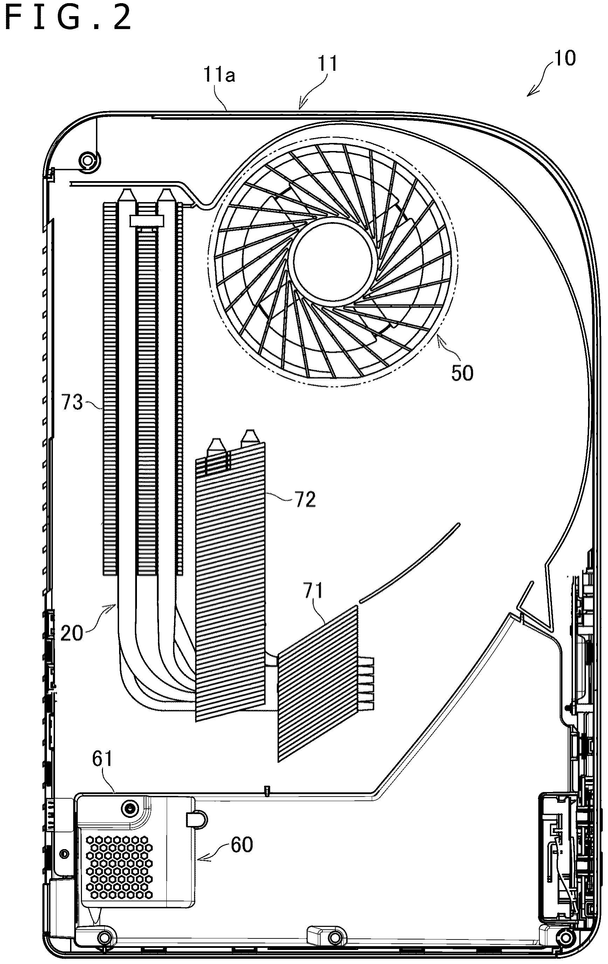

   FIG. 2 is a plan view illustrating components disposed within a housing of a device main body.
[FIG. 3A]

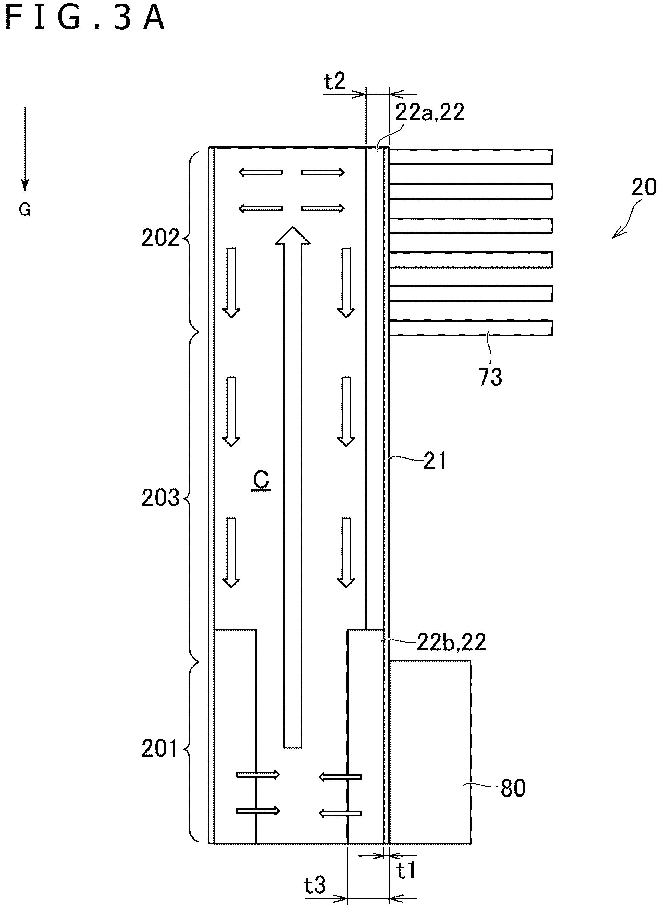

   FIG. 3A is a sectional view schematically illustrating a heat pipe and peripheral components in a state in which the electronic device is in the vertical posture.
[FIG. 3B]

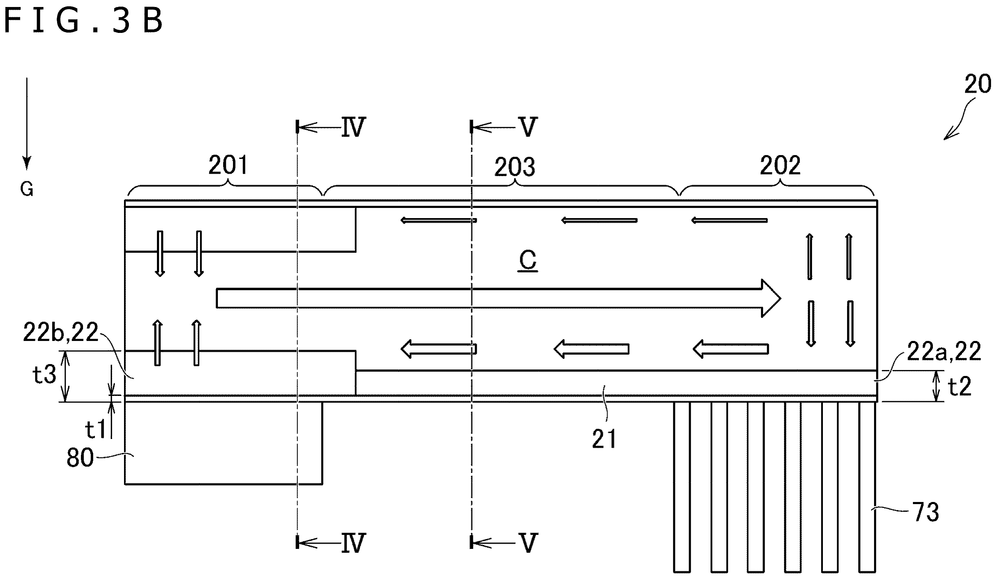

   FIG. 3B is a sectional view schematically illustrating the heat pipe and the peripheral components in a state in which the electronic device is in the horizontal posture.
[FIG. 4]

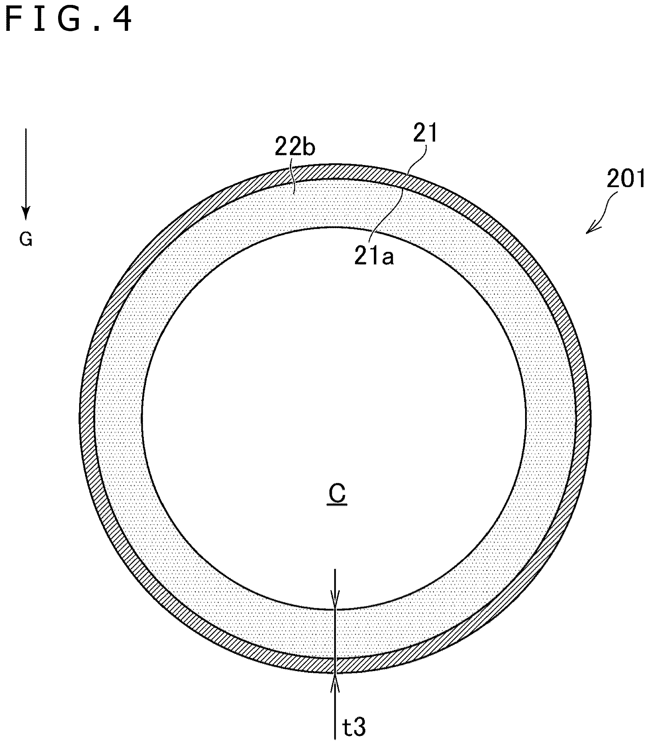

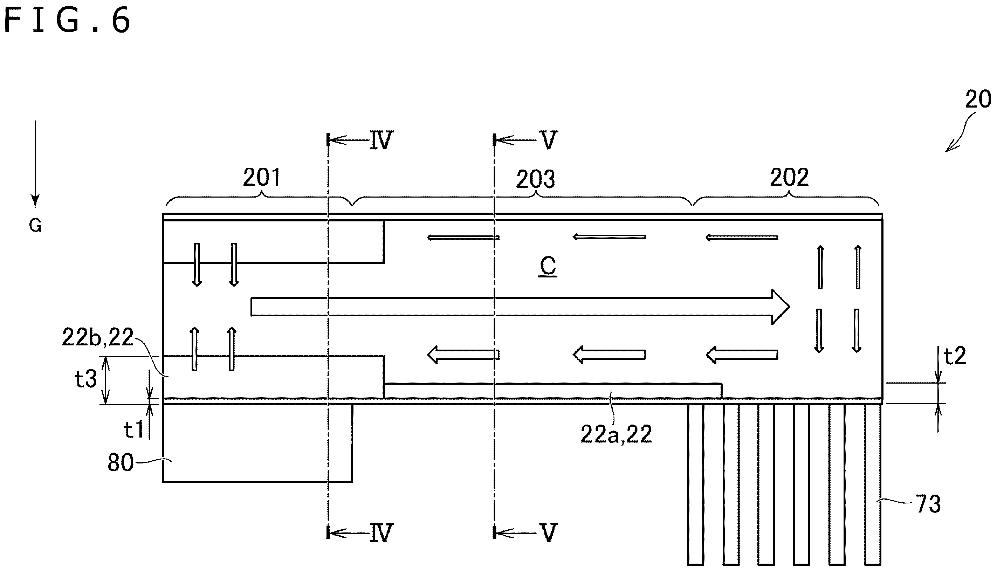

   FIG. 4 is a sectional view illustrating a cross section of the heat pipe taken along a cutting line IV-IV illustrated in FIG. 3B and FIG. 6.
[FIG. 5]

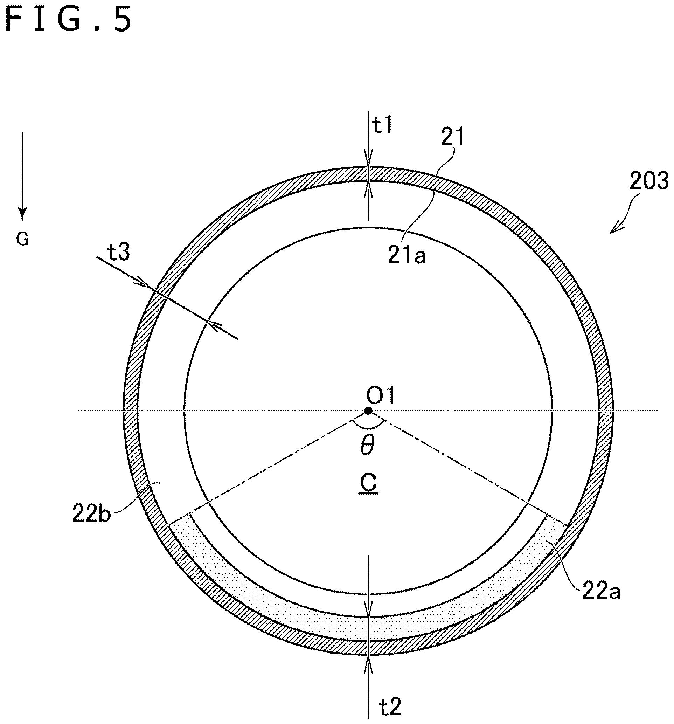

   FIG. 5 is a sectional view illustrating a cross section of the heat pipe taken along a cutting line V-V illustrated in FIG. 3B.
[FIG. 6]
   FIG. 6 is a sectional view schematically illustrating an example of a modification of the heat pipe.
[FIG. 7]

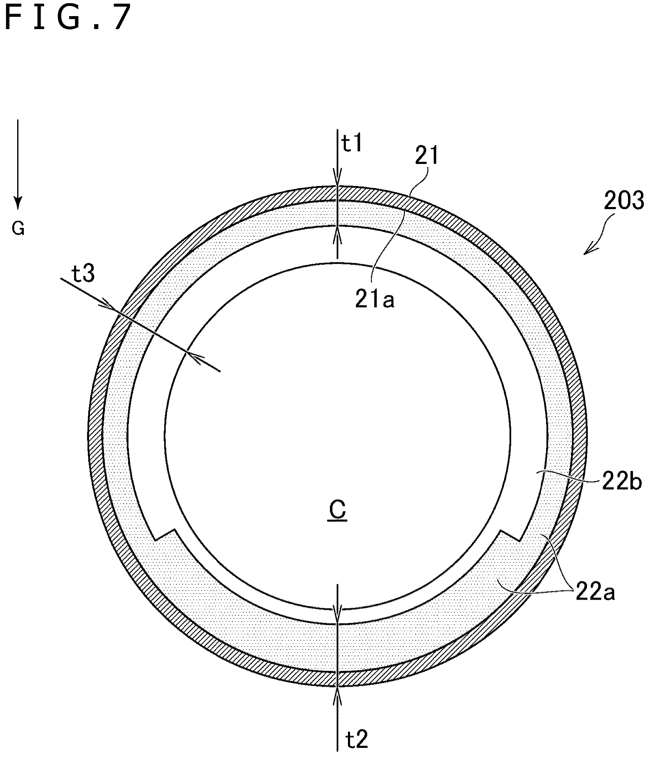

   FIG. 7 is a sectional view schematically illustrating an example of another modification of the heat pipe.
[FIG. 8A]

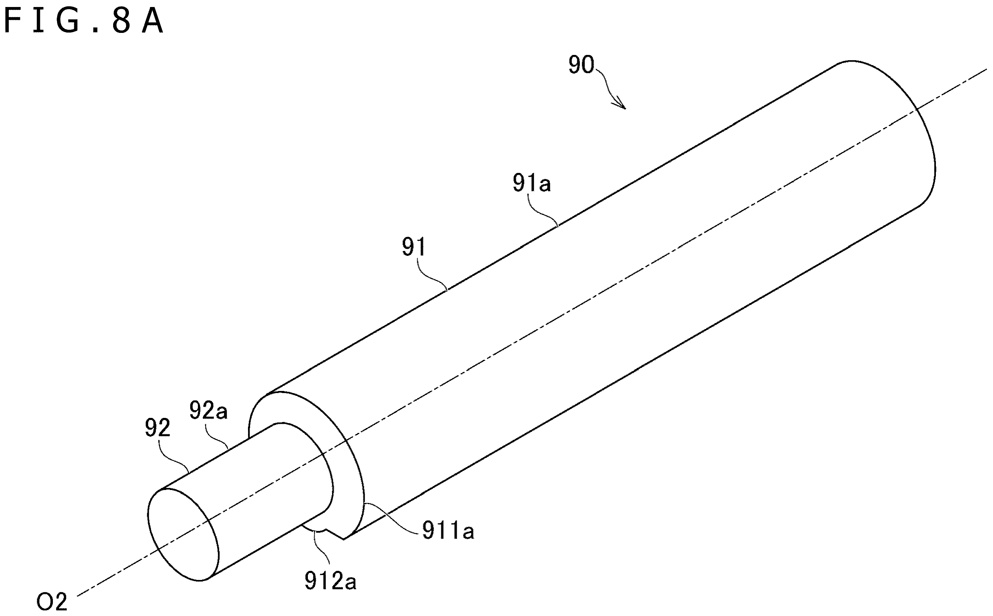

   FIG. 8A is a perspective view illustrating an instrument to be used for forming a sintered body layer.
[FIG. 8B]

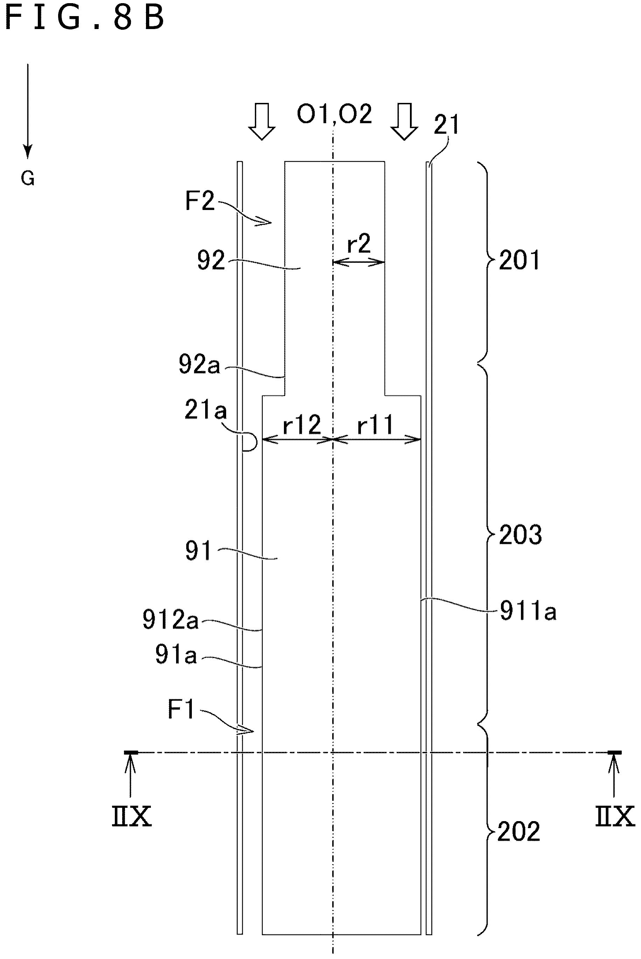

   FIG. 8B is a view schematically illustrating a manner in which filling with metal powder is performed.
[FIG. 8C]

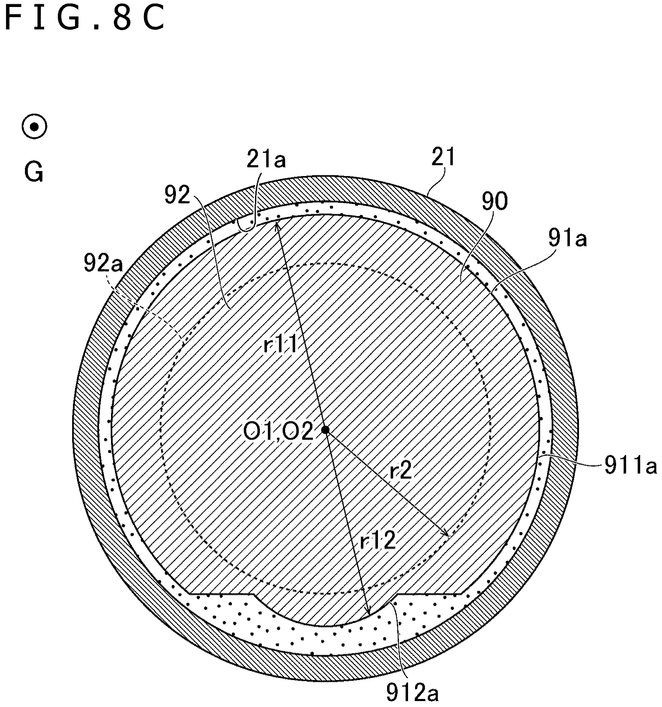

   FIG. 8C is a sectional view illustrating a manner in which a tubular body has been filled with the metal powder.

### [Description of Embodiment]

Hereinafter, an electronic device proposed in the present disclosure will be described with reference to the drawings. FIG. 1A is a perspective view illustrating an example of the electronic device in a vertical posture. FIG. 1B is a perspective view illustrating an example of the electronic device in a horizontal posture. FIG. 2 is a plan view illustrating components disposed within a housing of a device main body. In the following description, an arrow G illustrated in each figure indicates a direction in which gravity acts (hereinafter referred to as a gravity direction G). Further, in each figure, one side in the gravity direction G is regarded as the lower side, and the opposite side is regarded as the upper side.

### [Electronic Device]

The electronic device according to the present embodiment is preferably a game console, a personal computer, a server computer, or the like. FIG. 1A and FIG. 1B illustrate a game console as an example of the electronic device. As illustrated in FIG. 1A and FIG. 1B, an electronic device 10 may include a device main body 11, and a first cover 12 and a second cover 13 covering the device main body 11. The first cover 12 and the second cover 13 may have such sizes that they cover the entire device main body 11 as illustrated in FIG. 1A and FIG. 1B, or may have such sizes that they cover only part of the device main body 11.

### [Vertical Posture and Horizontal Posture of Electronic Device]

The electronic device 10 is preferably usable in at least two or more usage postures. The usage posture refers to the posture of the electronic device 10 being used by a user. The electronic device 10 can be disposed in the vertical posture as illustrated in FIG. 1A and the horizontal posture as illustrated in FIG. 1B.

In the present specification, the vertical posture refers to the posture of the electronic device 10 disposed such that at least part of a tubular body 21 of a heat pipe 20 to be described later extends substantially along the gravity direction G with an evaporation section 201 positioned on the lower side and a condensation section 202 positioned on the upper side. The horizontal posture refers to the posture of the electronic device 10 disposed such that at least part of the tubular body 21 of the heat pipe 20 extends in a direction (substantially horizontal direction) intersecting with the gravity direction G. The electronic device 10 is disposed in the horizontal posture with the second cover 13 positioned on the lower side.

There may be employed a structure in which, when being placed in the horizontal posture, the electronic device 10 is directly disposed on a surface (placement surface) of a desk or a floor, for example, thereby being supported thereon stably, or includes a stand member (not illustrated) attached thereto, thereby being stably supported therethrough on the placement surface. Similarly, there may be employed a structure in which, when being placed in the vertical posture, the electronic device 10 is directly disposed on the placement surface, thereby being supported thereon stably, or includes a stand member (not illustrated) attached thereto, thereby being stably supported therethrough on the placement surface.

### [Device Main Body]

The device main body 11 includes a housing 11a. As illustrated in FIG. 2, the housing 11a accommodates the heat pipe 20, a cooling fan 50, a power supply unit 60, heat sinks 71, 72, and 73 that are heat-dissipating components, and the like. Further, the housing 11a accommodates a circuit board, which is not illustrated. Electronic components that are heat-generating components (heat-generating component 80 to be described later with reference to FIG. 3A and the like) are mounted on the circuit board. The electronic components that are the heat-generating components are preferably a CPU (Central Processing Unit), a GPU (Graphical Processing Unit), and the like.

The power supply unit 60 uses a current supplied from an external power supply and supplies the current to various components that the device main body 11 includes, such as the CPU, as driving power thereof. The power supply unit 60 includes a case 61. A circuit board including a transformer, a rectifier circuit, and the like is accommodated within the case 61.

The heat sinks 71, 72, and 73 are directly connected to the heat-generating components such as the CPU, or are thermally connected to the heat-generating components through a heat-receiving block or the heat pipe 20. Each of the heat sinks 71, 72, and 73 preferably has a shape including a plurality of heat-dissipating fins, for example. The cooling fan 50 forms an air flow that passes through the inside of the case 61 of the power supply unit 60 or passes through the heat sinks 71, 72, and 73.

### [Heat Pipe]

Next, the configuration and function of the heat pipe 20 are described with reference to FIG. 3A to FIG. 5. FIG. 3A is a sectional view schematically illustrating the heat pipe and peripheral components in a state in which the electronic device is in the vertical posture. FIG. 3B is a sectional view schematically illustrating the heat pipe and the peripheral components in a state in which the electronic device is in the horizontal posture. FIG. 4 is a sectional view illustrating a cross section of the heat pipe taken along a cutting line IV-IV illustrated in FIG. 3B. FIG. 5 is a sectional view illustrating a cross section of the heat pipe taken along a cutting line V-V illustrated in FIG. 3B. Note that arrows illustrated within the tubular body 21 in FIG. 3A and FIG. 3B represent the circulation of a working fluid sealed in the tubular body 21.

The heat pipe 20 includes the tubular body 21 with a working fluid sealed therein and a sintered body layer 22 formed by sintering metal powder on an inner wall surface 21a of the tubular body 21. Note that sintering refers to solidifying a mass of powdered metal through heating at a high temperature but below the melting point of the metal.

The material of the tubular body 21 is not limited to a particular material, but the tubular body 21 preferably contains a metal with high thermal conductivity. The working fluid may be one appropriately selected depending on the material and the like of the tubular body 21 and is preferably water, for example.

The tubular body 21 is preferably disposed such that at least a portion thereof extends substantially along the gravity direction in the state in which the electronic device 10 is in the vertical posture. FIG. 3A and FIG. 3B illustrate a configuration in which the tubular body 21 extends straight in one direction, but the configuration is not limited to this, and part of the tubular body 21 may be bent or twisted.

The sintered body layer 22 is preferably formed by sintering copper powder, for example. Note that, in the following description, the sintered body layer is denoted by a reference symbol "22a" or "22b" depending on the location in which the sintered body layer is formed. In a case where there is no particular need to distinguish the sintered body layer from another in the description, it is simply referred to as the "sintered body layer 22."

The heat pipe 20 includes the evaporation section 201, the condensation section 202, and an intermediate section 203. Note that the evaporation section 201, the condensation section 202, and the intermediate section 203 are portions of the heat pipe 20 and are preferably configured in such a manner as to be continuously connected to one another, instead of being physically separated from one another.

The evaporation section 201 has an outer surface at least part of which is disposed in contact with the heat-generating component 80, and the working fluid evaporates in the evaporation section 201 due to heat from the heat-generating component 80. Note that the evaporation section 201 is not limited to such an arrangement that the tubular body 21 is directly in contact with the heat-generating component 80, and it is sufficient if the evaporation section 201 is disposed such that at least the working fluid sealed in the tubular body 21 evaporates due to the heat from the heat-generating component 80.

The condensation section 202 has an outer surface at least part of which is disposed in contact with the heat sink 73, and the working fluid condenses in the condensation section 202 due to the heat dissipation effect of the heat sink 73. Note that the condensation section 202 is not limited to such an arrangement that the tubular body 21 is directly in contact with the heat sink 73, and it is sufficient if the condensation section 202 is disposed such that at least the working fluid sealed in the tubular body 21 condenses due to the heat dissipation effect of the heat sink 73.

The intermediate section 203 is disposed between the evaporation section 201 and the condensation section 202. That is, one end portion of the heat pipe 20 is the evaporation section 201, the other end portion thereof is the condensation section 202, and the portion between the evaporation section 201 and the condensation section 202 is the intermediate section 203.

The working fluid present in the evaporation section 201 increases in temperature due to the heat from the heat-generating component 80 and vaporizes. The vaporized working fluid, which is now gas, moves to the condensation section 202 through the intermediate section 203. In the heat pipe 20, a hollow (hereinafter referred to as a hollow C) is formed inside the tubular body 21 and the sintered body layer 22. The hollow C serves as a flow path through which the vaporized working fluid moves.

The working fluid that has moved to the condensation section 202 condenses due to the heat dissipation effect of the heat sink 73 and liquefies. The liquefied working fluid, which is now liquid, moves along the inner wall of the heat pipe 20 to the evaporation section 201 through the intermediate section 203. Moreover, the working fluid that has moved to the evaporation section 201 increases in temperature due to the heat from the heat-generating component 80 and vaporizes. In this way, in the heat pipe 20, the working fluid is refluxed within the tubular body 21 to transport heat from the evaporation section 201 to the condensation section 202, thereby preventing the heat-generating component 80 from increasing in temperature.

Further, in the heat pipe 20, the sintered body layer 22 is formed on the inner wall surface 21a of the tubular body 21 to move the liquefied working fluid from the condensation section 202 to the evaporation section 201. The sintered body layer 22 has a large number of voids formed depending on the shape, particle size, and the like of the sintered metal powder. The liquefied working fluid can move within the sintered body layer 22 due to the capillary force of the sintered body layer 22. That is, the liquefied working fluid can move from the condensation section 202 to the evaporation section 201 through the voids of the sintered body layer 22.

Here, in the state in which the electronic device 10 is in the vertical posture, since the direction of movement of the working fluid from the condensation section 202 to the evaporation section 201 matches the gravity direction G, the working fluid can move smoothly due to the influence of gravity in addition to the above-mentioned capillary force. On the other hand, in the state in which the electronic device 10 is in the horizontal posture, since the direction of movement of the working fluid from the condensation section 202 to the evaporation section 201 differs from the gravity direction G, the working fluid is less likely to move than that in the state in which the electronic device 10 is in the vertical posture.

Further, in the circulation of the working fluid, the movement of the vaporized working fluid from the evaporation section 201 to the condensation section 202 and the movement of the liquefied working fluid from the condensation section 202 to the evaporation section 201 are performed in parallel. In other words, in the circulation of the working fluid, the movement of the vaporized working fluid from the evaporation section 201 to the condensation section 202 and the movement of the liquefied working fluid from the condensation section 202 to the evaporation section 201 form a counterflow. Thus, the vaporized working fluid generates a force that acts as resistance to the movement of the liquefied working fluid. Therefore, the circulation of the working fluid is affected depending on the flow velocity of the vaporized working fluid, in some cases.

Accordingly, the heat pipe 20 adopts a configuration in which, as illustrated in FIG. 5, the intermediate section 203 includes, in a cross section taken along a direction orthogonal to (direction intersecting with) the extension direction of the tubular body 21, a first thick portion having a first thickness t1 and a second thick portion having a second thickness t2. Note that the thickness of the tubular body 21 may be the same regardless of portions thereof.

In the present embodiment, the second thick portion includes a combination of the tubular body 21 and the sintered body layer 22a. That is, the thickness t2 is the total thickness of the thickness of the tubular body 21 and the thickness of the sintered body layer 22a. On the other hand, the first thick portion only includes the tubular body 21. That is, the thickness t1 is the thickness of the tubular body 21 itself. For this reason, the second thickness t2 of the second thick portion is larger than the first thickness t1 of the first thick portion. In this way, the sintered body layer 22 is formed on a predetermined portion of the inner wall surface 21a in the intermediate section 203 of the heat pipe 20. In other words, in the heat pipe 20, the intermediate section 203 includes a portion in which the sintered body layer 22 is not formed on the inner wall surface 21a.

Since the intermediate section 203 includes the portion in which the sintered body layer 22a is not formed, the inner diameter of the hollow C in the intermediate section 203 is relatively wide. That is, the flow path in the intermediate section 203 is wider than that in a configuration in which the sintered body layer 22 is formed over the entire circumference of the inner wall surface 21a. Therefore, the flow velocity of the vaporized working fluid in the intermediate section 203 is slower than that in the configuration in which the sintered body layer 22 is formed over the entire circumference.

Further, in the heat pipe 20, as illustrated in FIG. 3B and FIG. 5, the sintered body layer 22a is formed to be positioned only at a lower portion of the intermediate section 203 in the state in which the electronic device 10 is in the horizontal posture.

In the state in which the electronic device 10 is in the horizontal posture, the working fluid that has liquefied in the condensation section 202 moves to a lower portion of the heat pipe 20 due to the influence of gravity. Therefore, the working fluid moves to the evaporation section 201 due to the capillary force of the sintered body layer 22a formed at the lower portion of the intermediate section 203.

Note that, while FIG. 5 illustrates an example in which the sintered body layer 22a is formed with a predetermined width in the peripheral direction at the lower portion of the intermediate section 203, the shape of the sintered body layer 22a is not limited to this. The sintered body layer 22a is preferably formed such that at least a portion thereof is at the lowermost portion of the inner wall surface 21a of the tubular body 21 in the intermediate section 203 in the state in which the electronic device 10 is in the horizontal posture. That is, the second thick portion having the thickness t2 preferably includes at least the lowermost portion of the tubular body 21 in the intermediate section 203 in the state in which the electronic device 10 is in the horizontal posture.

Further, the sintered body layer 22a is preferably formed to be positioned below a center O1 of the tubular body 21 in the state in which the electronic device 10 is in the horizontal posture. That is, the second thick portion having the thickness t2 is preferably formed to be positioned below the center O1 (see FIG. 5) of the tubular body 21 in the cross section taken along the direction orthogonal to the extension direction of the tubular body 21, in the state in which the electronic device 10 is in the horizontal posture. In addition, it is preferable that the sintered body layer 22a be formed in a range in which a central angle θ illustrated in FIG. 5 is 120° or more but less than 180°, for example, in the tubular body 21 having a circular cross-sectional shape.

The condensation section 202 preferably includes the first thick portion having the first thickness t1 and the second thick portion having the second thickness t2 in the cross section taken along the direction orthogonal to the extension direction of the tubular body 21. Further, the second thick portion of the intermediate section 203 is preferably connected to the second thick portion of the condensation section 202. That is, the sintered body layer 22a of the intermediate section 203 and the sintered body layer 22a of the condensation section 202 are preferably formed substantially flush without a step in the extension direction. In this way, the thickness of the condensation section 202 is made similar to the thickness of the intermediate section 203, so that the flow path for the working fluid can be widened.

As illustrated in FIG. 4, the sintered body layer 22b formed on the inner wall surface 21a in the evaporation section 201 is preferably formed over the entire circumference in the cross section taken along the direction orthogonal to the extension direction of the tubular body 21. Further, as illustrated in FIG. 3A and FIG. 3B, the sintered body layer 22b formed on the inner wall surface 21a in the evaporation section 201 is preferably formed over the entire length of the evaporation section 201 in the extension direction of the tubular body 21. In addition, the evaporation section 201 preferably includes a third thick portion having a third thickness t3. The third thick portion includes a combination of the tubular body 21 and the sintered body layer 22b and has a larger thickness than the second thickness t2 of the second thick portion. That is, the thickness of the sintered body layer 22b formed on the inner wall surface 21a of the tubular body 21 in the evaporation section 201 is preferably larger than the thickness of the sintered body layer 22a formed on the inner wall surface 21a of the tubular body 21 in the intermediate section 203.

However, the shape of the sintered body layer 22b formed on the inner wall surface 21a of the tubular body 21 in the evaporation section 201 is not limited to the example illustrated in FIG. 4. Also in the evaporation section 201, the sintered body layer 22b may be formed only at a lower portion of the evaporation section 201 in the state in which the electronic device 10 is in the horizontal posture.

Further, as illustrated in FIG. 3A and the like, at least a portion of the intermediate section 203 on the evaporation section 201 side preferably includes the third thick portion having the third thickness t3. In addition, the third thick portion of the intermediate section 203 is preferably connected to the third thick portion of the evaporation section 201. That is, the third thick portion is preferably provided not only in the evaporation section 201 but also partly in the intermediate section 203. In this way, the sintered body layer 22 is formed thickly in a region which is likely to be affected by resistance of the vaporized working fluid, thereby allowing the liquefied working fluid to easily return to the evaporation section 201. As a result, the circulation of the working fluid becomes smoother.

Further, as illustrated in FIG. 5, the first thick portion and the second thick portion of the intermediate section 203 preferably face each other at least in part through the center O1 of the tubular body 21. That is, the cross-sectional shape of the intermediate section 203 is preferably asymmetrical with the center O1 of the tubular body 21 as the center of symmetry.

Further, in the present embodiment, an example in which the heat pipe 20 is provided in the electronic device 10 to be used in the vertical posture or the horizontal posture has been described, but the present embodiment is not limited to this. For example, the heat pipe 20 may be provided in an electronic device to be used in one usage posture. In this case, the usage posture of the electronic device is preferably the horizontal posture described in the present embodiment.

Further, in the present embodiment, the tubular body 21 having a circular cross-sectional shape has been described by way of example, but the tubular body 21 is not limited to this. That is, the cross-sectional shape of the tubular body 21 may be elliptical or rectangular.

Further, although not illustrated, a plurality of grooves extending in the extension direction of the tubular body 21 are preferably formed in the inner wall surface 21a of the tubular body 21 in each of the evaporation section 201, the condensation section 202, and the intermediate section 203. Besides, the sintered body layer 22 is preferably formed in the plurality of grooves formed in the inner wall surface 21a of the tubular body 21. Since capillary force can also be generated in the plurality of grooves, the movement of the liquefied working fluid can be performed more smoothly.

### [Conclusion]

As described above, in the heat pipe 20 according to the present embodiment, the flow path for the working fluid can be made relatively wide without an increase in the diameter of the tubular body 21 itself. Therefore, the flow velocity of the vaporized working fluid moving from the evaporation section 201 to the condensation section 202 can be made relatively slow. Further, there is adopted a configuration in which the sintered body layer 22 is formed at the lower portion of the tubular body 21 in the state in which the electronic device 10 is in the horizontal posture. Thus, the working fluid easily moves due to capillary force even in the state in which the electronic device 10 is in the horizontal posture. Therefore, the movement of the liquefied working fluid from the condensation section 202 to the evaporation section 201 can be performed smoothly. As a result, heat circulation can be performed efficiently regardless of the usage posture of the electronic device 10.

Further, in the heat pipe 20 according to the present embodiment, the amount of metal powder used for forming the sintered body layer 22 can be reduced compared to a configuration in which the sintered body layer 22 is formed on the entire circumference of the inner wall surface 21a of the tubular body 21. Therefore, manufacturing costs can be reduced.

### [Modifications]

FIG. 6 is a view schematically illustrating an example of a modification of the heat pipe. FIG. 7 is a view schematically illustrating an example of another modification of the heat pipe.

In FIG. 3A and the like related to the present embodiment, there has been illustrated an example in which the position and thickness of the sintered body layer 22 in the condensation section 202 are similar to those in the intermediate section 203. However, the sintered body layer 22 is not limited to this and may not be formed in part of the condensation section 202 as illustrated in FIG. 6, for example. Further, although not illustrated, in the condensation section 202, a sintered body layer having a smaller thickness than the sintered body layer 22a formed in the intermediate section 203 may be formed. That is, the thickness of a combination of the tubular body 21 and the sintered body layer 22 may gradually decrease from the evaporation section 201 side toward the condensation section 202 side. With such a configuration, the flow path for the vaporized working fluid can be more widened. As a result, the fluid of the vaporized working fluid can be slowed down, and the movement of the liquefied working fluid can be performed smoothly. Further, since the amount of metal powder used for forming the sintered body layer 22 can be reduced, manufacturing costs can be reduced.

Further, in FIG. 3A and the like related to the present embodiment, there has been illustrated an example in which the sintered body layer 22a is not formed in part of the intermediate section 203. However, the sintered body layer 22a is not limited to this and may be formed on the entire circumference in the peripheral direction of the tubular body 21 in the intermediate section 203 as illustrated in FIG. 7, for example. That is, the first thick portion having the first thickness t1 in the intermediate section 203 preferably includes a combination of the tubular body 21 and the sintered body layer 22a. That is, the sintered body layer 22a may be formed on the entire circumference in the intermediate section 203 so as to partially have a different thickness in the peripheral direction, that is, to include a portion having a smaller thickness than other portions. As illustrated in FIG. 7, the first thick portion and the second thick portion of the intermediate section 203 preferably face each other at least in part through the center of the tubular body 21. That is, the cross-sectional shape of the intermediate section 203 is preferably asymmetrical with the center of the tubular body 21 as the center of symmetry. Further, as illustrated in FIG. 7, the second thick portion having the second thickness t2 is preferably disposed on the lower side in the state in which the electronic device 10 is in the horizontal posture. With such a configuration, the flow path for the vaporized working fluid can be made relatively wide, and the capillary force of the sintered body layer 22 can be generated on the entire circumference in the peripheral direction of the tubular body 21. This enables efficient heat circulation.

### [Method for Manufacturing Heat Pipe]

Next, with reference to FIG. 8A to FIG. 8C, a method for manufacturing a heat pipe is described. FIG. 8A is a perspective view of an instrument to be used for forming a sintered body layer. FIG. 8B is a view schematically illustrating a manner in which filling with metal powder is performed. FIG. 8C is a view illustrating a manner in which a tubular body has been filled with the metal powder, and is a cross section taken along the line IIX-IIX illustrated in FIG. 8B. Note that a dashed line illustrated in FIG. 8C is an imaginary line indicating a second extension part 92 to be described later.

Here, there is described a method for manufacturing a heat pipe in which the sintered body layer 22a is formed on the entire circumference in the peripheral direction of the tubular body 21 in the intermediate section 203, which is similar to the heat pipe 20 illustrated in FIG. 7 as described above. Note that O2 illustrated in FIG. 8A to FIG. 8C indicates the center of an instrument 90 in a cross section taken along a direction orthogonal to the extension direction of the instrument 90.

In the manufacturing process of the heat pipe, the instrument 90 illustrated in FIG. 8A is used to form the sintered body layer 22. The instrument 90 is used as a mold when the sintered body layer 22 is formed. It is preferable that the instrument 90 have a shape extending in the extension direction of the tubular body 21 and be sized to be insertable into the tubular body 21.

The instrument 90 includes a first extension part 91 and the cylindrical second extension part 92. The first extension part 91 has a shape extending in the same direction as the tubular body 21. The second extension part 92 has a shape extending from an end portion of the first extension part 91 in the same direction as the first extension part 91 and has a smaller diameter than the first extension part 91. That is, as illustrated in FIG. 8C, a length r2 from the center O2 of the instrument 90 to an outer wall surface 92a of the second extension part 92 is smaller than lengths r11 and r12 from the center O2 of the instrument 90 to an outer wall surface 91a in the cross section taken along the direction intersecting with the extension direction of the instrument 90.

Further, in the cross section taken along the direction orthogonal to the extension direction of the instrument 90, the first extension part 91 includes a portion having a small length from the center O2 of the instrument 90 to the outer wall surface 91a in the cross section. Specifically, as illustrated in FIG. 8C, a portion of the first extension part 91 has the length r11 as the length from the center O2 to the outer wall surface 91a, and another portion thereof has the length r12, which is smaller than the length r11. That is, the outer wall surface 91a of the first extension part 91 has a first outer peripheral surface 911a having a radius of r11 and a second outer peripheral surface 912a having a radius of r12, and the radius of the second outer peripheral surface 912a (second radius) is smaller than the radius of the first outer peripheral surface 911a (first radius).

First, as illustrated in FIG. 8B, the instrument 90 is inserted into the tubular body 21. The instrument 90 is preferably inserted such that the center O2 thereof aligns with the center O1 of the tubular body 21. In this state, a gap is formed between the tubular body 21 and the instrument 90. Specifically, between the inner wall surface 21a of the tubular body 21 and the outer wall surface 91a of the first extension part 91, a first filling region F1 to be filled with metal powder is formed. Further, between the inner wall surface 21a of the tubular body 21 and the outer wall surface 92a of the second extension part 92, a second filling region F2 to be filled with metal powder is formed. The second filling region F2 has a larger width in the thickness direction of the tubular body 21 than the first filling region F1. The first filling region F1 includes a region part of which has a large width in the thickness direction of the tubular body 21.

As illustrated in FIG. 8B, the first filling region F1 is a region for forming the sintered body layer 22 in the whole condensation section 202 and part of the intermediate section 203 of the heat pipe. The second filling region F2 is a region for forming the sintered body layer 22 in the whole evaporation section 201 and part of the intermediate section 203 of the heat pipe.

As illustrated in FIG. 8B, the instrument 90 is preferably inserted into the tubular body 21 such that the first extension part 91 is positioned on the lower side of the second extension part 92 in the gravity direction G. Further, the tubular body 21 and the instrument 90 are preferably fixed such that the relative positions thereof do not change in the state in which the instrument 90 is inserted into the tubular body 21. Note that, although not illustrated, an end portion of the tubular body 21 on the lower side in the gravity direction may be subjected to terminal processing by swaging or the like, for example.

Next, the first filling region F1 and the second filling region F2 are filled with metal powder. Each arrow illustrated in FIG. 8B indicates the direction of movement of metal powder when filling with the metal powder is performed. That is, FIG. 8B illustrates a manner in which the metal powder is introduced from the second extension part 92 side in the extension direction of the instrument 90. The first filling region F1 is first filled with the metal powder, and the second filling region F2 is then filled with it. Then, vibration is preferably applied to the entire region, for example, to complete the filling.

After that, the tubular body 21 is sintered together with the instrument 90 to form the sintered body layer 22. After the sintering, the instrument 90 is preferably withdrawn from inside the tubular body 21. With this, the metal powder with which the first filling region F1 is filled serves as the sintered body layer 22a in the first thick portion and the second thick portion. The metal powder with which the second filling region F2 is filled serves as the sintered body layer 22b in the third thick portion.

Note that the shape and size of the instrument 90 are not limited to those illustrated in FIG. 8A. For example, in a case where the heat pipe 20 illustrated in FIG. 3A is manufactured, the diameter of a portion of the first extension part 91 of the instrument 90 which is used for forming the first thick portion is preferably the same as the diameter of the inner wall surface 21a of the tubular body 21. That is, the length r11 from the center O2 to the outer wall surface 91a of the first extension part 91 is preferably the same as the inner diameter of the tubular body 21. Further, the instrument 90 is not limited to one including one member, and may include a plurality of members for forming the first filling region F1 and the second filling region F2.

### [Supplementary Note]

For example, the heat pipe, the electronic device, the instrument, and the method for manufacturing the heat pipe can also take the following configurations.
(1) A heat pipe that includes a tubular body in which a working fluid is to be sealed and a sintered body layer formed by sintering metal powder on an inner wall surface of the tubular body, the heat pipe including an evaporation section in which the working fluid evaporates, a condensation section in which the working fluid condenses, and an intermediate section positioned between the evaporation section and the condensation section, in which at least the intermediate section includes, in a cross section taken along a direction intersecting with an extension direction of the heat pipe, a first thick portion having a first thickness and a second thick portion having a second thickness, the second thickness being larger than the first thickness, the first thick portion and the second thick portion of the intermediate section face each other at least in part through a center of the tubular body in the cross section, and the second thick portion includes a combination of the tubular body and the sintered body layer.
(2) The heat pipe according to (1), in which the first thick portion includes a combination of the tubular body and the sintered body layer.
(3) The heat pipe according to (1), in which the first thick portion only includes the tubular body.
(4) The heat pipe according to any one of (1) through (3), in which at least the evaporation section includes a third thick portion having a third thickness, and the third thick portion includes a combination of the tubular body and the sintered body layer and has a larger thickness than the second thick portion.
(5) The heat pipe according to (4), in which at least a portion of the intermediate section on a side of the evaporation section includes the third thick portion.
(6) The heat pipe according to (4) or (5), in which the third thick portion of the intermediate section is connected to the third thick portion of the evaporation section.
(7) The heat pipe according to any one of (1) through (6), in which the condensation section includes, in a cross section taken along a direction intersecting with an extension direction of the tubular body, the first thick portion and the second thick portion.
(8) The heat pipe according to (7), in which the second thick portion of the intermediate section is connected to the second thick portion of the condensation section.
(9) The heat pipe according to any one of (1) through (8), in which the sintered body layer on an inner wall surface of the evaporation section is formed over an entire circumference in a cross section taken along a direction intersecting with an extension direction of the tubular body.
(10) The heat pipe according to any one of (1) through (9), in which the sintered body layer on the inner wall surface of the evaporation section is formed over an entire length of the evaporation section in the extension direction of the tubular body.
(11) The heat pipe according to any one of (1) through (10), in which a thickness of the combination of the tubular body and the sintered body layer gradually decreases from a side of the evaporation section toward a side of the condensation section.
(12) An electronic device having a housing for accommodating a heat-generating component, a heat-dissipating component, and a heat pipe that includes a tubular body in which a working fluid is to be sealed and a sintered body layer formed by sintering metal powder on an inner wall surface of the tubular body, the heat pipe including an evaporation section in which the working fluid evaporates due to heat from the heat-generating component, a condensation section in which the working fluid condenses due to a heat dissipation effect of the heat-dissipating component, and an intermediate section positioned between the evaporation section and the condensation section, in which at least the intermediate section includes, in a cross section taken along a direction intersecting with an extension direction of the heat pipe, a first thick portion having a first thickness and a second thick portion having a second thickness, the second thickness being larger than the first thickness, the first thick portion and the second thick portion of the intermediate section face each other at least in part through a center of the tubular body in the cross section, and the second thick portion includes a combination of the tubular body and the sintered body layer.
(13) The electronic device according to (12), in which at least part of the evaporation section is disposed in contact with the heat-generating component, and at least part of the condensation section is disposed in contact with the heat-dissipating component.
(14) The electronic device according to (12) or (13), in which at least part of the second thick portion is provided to be positioned at a lowermost portion of the heat pipe when the electronic device is in a predetermined usage posture.
(15) The electronic device according to any one of (12) through (14), in which the second thick portion is provided to be positioned below a center of the tubular body in a vertical direction when the electronic device is in a predetermined usage posture.
(16) An instrument to be used for forming a sintered body layer in a heat pipe that includes a tubular body in which a working fluid is to be sealed and the sintered body layer formed by sintering metal powder on an inner wall surface of the tubular body, the instrument including a first extension part extending in an extension direction of the tubular body and a second extension part extending in the extension direction of the tubular body from an end portion of the first extension part, in which a length from a center of the second extension part to an outer wall surface thereof in a cross section taken along a direction intersecting with an extension direction of the second extension part is smaller than a length from a center of the first extension part to an outer wall surface thereof in a cross section taken along a direction intersecting with an extension direction of the first extension part, and the first extension part includes a portion having a small length from the center to the outer wall surface of the first extension part in the cross section taken along the direction intersecting with the extension direction of the first extension part.
(17) The instrument according to (16), in which the second extension part is cylindrical, and the outer wall surface of the first extension part has a shape including a first outer peripheral surface having a first radius and a second outer peripheral surface having a second radius, the second radius being smaller than the first radius.
(18) A method for manufacturing a heat pipe that includes a tubular body in which a working fluid is to be sealed and a sintered body layer formed by sintering metal powder on an inner wall surface of the tubular body, the method including the steps of inserting an instrument extending in an extension direction of the tubular body into the tubular body, filling a gap between the inner wall surface of the tubular body and an outer wall surface of the instrument with metal powder, and forming the sintered body layer in the gap by sintering the metal powder, in which the gap includes a first filling region and a second filling region, the second filling region has a larger width in a thickness direction of the tubular body than the first filling region, and the first filling region includes a region part of which has a large width in the thickness direction of the tubular body.

## Claims

1. A heat pipe that includes a tubular body in which a working fluid is to be sealed and a sintered body layer formed by sintering metal powder on an inner wall surface of the tubular body,
the heat pipe comprising:
an evaporation section in which the working fluid evaporates;
a condensation section in which the working fluid condenses; and
an intermediate section positioned between the evaporation section and the condensation section, wherein at least the intermediate section includes, in a cross section taken along a direction intersecting with an extension direction of the heat pipe, a first thick portion having a first thickness and a second thick portion having a second thickness, the second thickness being larger than the first thickness,
the first thick portion and the second thick portion of the intermediate section face each other at least in part through a center of the tubular body in the cross section, and
the second thick portion includes a combination of the tubular body and the sintered body layer.

2. The heat pipe according to claim 1, wherein
the first thick portion includes a combination of the tubular body and the sintered body layer.

3. The heat pipe according to claim 1, wherein
the first thick portion only includes the tubular body.

4. The heat pipe according to claim 1, wherein
at least the evaporation section includes a third thick portion having a third thickness, and
the third thick portion includes a combination of the tubular body and the sintered body layer and has a larger thickness than the second thick portion.

5. The heat pipe according to claim 4, wherein
at least a portion of the intermediate section on a side of the evaporation section includes the third thick portion.

6. The heat pipe according to claim 5, wherein
the third thick portion of the intermediate section is connected to the third thick portion of the evaporation section.

7. The heat pipe according to claim 1, wherein
the condensation section includes, in a cross section taken along a direction intersecting with an extension direction of the tubular body, the first thick portion and the second thick portion.

8. The heat pipe according to claim 7, wherein
the second thick portion of the intermediate section is connected to the second thick portion of the condensation section.

9. The heat pipe according to claim 1, wherein
the sintered body layer on an inner wall surface of the evaporation section is formed over an entire circumference in a cross section taken along a direction intersecting with an extension direction of the tubular body.

10. The heat pipe according to claim 9, wherein
the sintered body layer on the inner wall surface of the evaporation section is formed over an entire length of the evaporation section in the extension direction of the tubular body.

11. The heat pipe according to claim 1, wherein
a thickness of the combination of the tubular body and the sintered body layer gradually decreases from a side of the evaporation section toward a side of the condensation section.

12. An electronic device having a housing for accommodating a heat-generating component,
a heat-dissipating component, and
a heat pipe that includes a tubular body in which a working fluid is to be sealed and a sintered body layer formed by sintering metal powder on an inner wall surface of the tubular body,
the heat pipe including
an evaporation section in which the working fluid evaporates due to heat from the heat-generating component,
a condensation section in which the working fluid condenses due to a heat dissipation effect of the heat-dissipating component, and
an intermediate section positioned between the evaporation section and the condensation section, wherein at least the intermediate section includes, in a cross section taken along a direction intersecting with an extension direction of the heat pipe, a first thick portion having a first thickness and a second thick portion having a second thickness, the second thickness being larger than the first thickness,
the first thick portion and the second thick portion of the intermediate section face each other at least in part through a center of the tubular body in the cross section, and
the second thick portion includes a combination of the tubular body and the sintered body layer.

13. The electronic device according to claim 12, wherein
at least part of the evaporation section is disposed in contact with the heat-generating component, and
at least part of the condensation section is disposed in contact with the heat-dissipating component.

14. The electronic device according to claim 12, wherein at least part of the second thick portion is provided to be positioned at a lowermost portion of the heat pipe when the electronic device is in a predetermined usage posture.

15. The electronic device according to claim 12, wherein the second thick portion is provided to be positioned below a center of the tubular body in a vertical direction when the electronic device is in a predetermined usage posture.

16. An instrument to be used for forming a sintered body layer in a heat pipe that includes a tubular body in which a working fluid is to be sealed and the sintered body layer formed by sintering metal powder on an inner wall surface of the tubular body,
the instrument comprising:
a first extension part extending in an extension direction of the tubular body; and
a second extension part extending in the extension direction of the tubular body from an end portion of the first extension part, wherein
a length from a center of the second extension part to an outer wall surface thereof in a cross section taken along a direction intersecting with an extension direction of the second extension part is smaller than a length from a center of the first extension part to an outer wall surface thereof in a cross section taken along a direction intersecting with an extension direction of the first extension part, and
the first extension part includes a portion having a small length from the center to the outer wall surface of the first extension part in the cross section taken along the direction intersecting with the extension direction of the first extension part.

17. The instrument according to claim 16, wherein
the second extension part is cylindrical, and
the outer wall surface of the first extension part has a shape including a first outer peripheral surface having a first radius and a second outer peripheral surface having a second radius, the second radius being smaller than the first radius.

18. A method for manufacturing a heat pipe that includes a tubular body in which a working fluid is to be sealed and a sintered body layer formed by sintering metal powder on an inner wall surface of the tubular body,
the method comprising the steps of:
inserting an instrument extending in an extension direction of the tubular body into the tubular body;
filling a gap between the inner wall surface of the tubular body and an outer wall surface of the instrument with metal powder; and
forming the sintered body layer in the gap by sintering the metal powder, wherein
the gap includes a first filling region and a second filling region,
the second filling region has a larger width in a thickness direction of the tubular body than the first filling region, and
the first filling region includes a region part of which has a large width in the thickness direction of the tubular body.
